**Europäisches Patentamt**

**European Patent Office**

**Office européen des brevets**

(19)

(11) Numéro de publication: **0 083 535**
**B1**

(12)

# FASCICULE DE BREVET EUROPEEN

(45) Date de publication du fascicule du brevet:
**12.03.86**

(21) Numéro de dépôt: **82402371.7**

(22) Date de dépôt: **23.12.82**

(51) Int. Cl.⁴: **H 01 G 13/00,** B 65 G 33/06,
H 05 K 13/02

(54) Appareil de stockage et de transfert mécanique de condensateurs électriques mères.

(30) Priorité: **31.12.81 FR 8124582**

(43) Date de publication de la demande:
**13.07.83 Bulletin 83/28**

(45) Mention de la délivrance du brevet:
**12.03.86 Bulletin 86/11**

(84) Etats contractants désignés:
**DE GB NL**

(56) Documents cités:
**FR - A - 2 144 635**
**FR - A - 2 461 665**
**US - A - 3 168 183**
**US - A - 3 308 930**

(73) Titulaire: **L.C.C.-C.I.C.E. - COMPAGNIE EUROPEENNE DE COMPOSANTS ELECTRONIQUES, 50, rue Jean-Pierre Timbaud B.P. 301, F-92402 Courbevoie (FR)**

(72) Inventeur: **Adler, Arno, THOMSON-CSF SCPI 173, bld Haussmann, F-75379 Paris Cedex 08 (FR)**

(74) Mandataire: **Ruelian-Lemonnier, Brigitte et al, THOMSON-CSF SCPI 173, boulevard Haussmann, F-75379 Paris Cedex 08 (FR)**

ACTORUM AG

## Description

La présente invention concerne un appareil de stockage et de transfert mécanique de condensateurs mères en forme de barreaux sensiblement parallélépipédiques présentant une courbure, le transfert s'effectuant parallèlement à l'un des côtés des barreaux.

Il est connu, par exemple du brevet français N° 903 040 de fabriquer des condensateurs par empilement à plat ou sur une roue de grand diamètre de films de matière plastique métallisés. Après réalisation des connexions latérales de ces empilements de forme parallélépipédique, ceux-ci sont ensuite découpés en condensateurs unitaires par tronçonnage radial. Ces barreaux parallélépipédiques ainsi formés peuvent avoir une longueur supérieure à un mètre et le problème de leur manutention automatique en vue du tronçonnage se pose, en particulier pour ceux qui présentent une courbure naturelle due au bobinage sur la roue.

Il est connu d'utiliser pour le stockage et le transfert de moyens de ce type des convoyeurs à tapis ou à courroie. On connait aussi par le brevet américain US-A-3 168 183 des dispositifs de transfert de tubes constitués par des vis sans fin. Toutefois, ces convoyeurs connus présentent l'inconvénient de ne pas épouser la forme de l'empilement, entrainant ainsi des dégradations préjudiciables aux condensateurs. En particulier, on note que le transport à plat de ces barreaux de condensateurs obtenus par bobinage sur une roue de grand diamètre provoque le décollement des couches superficielles au niveau des connexions latérales de schoopage. De plus, ces tapis convoyeurs nécessitent beaucoup de place car les barreaux doivent être disposés à la suite les uns des autres pour pouvoir être découpés un par un à la sortie du convoyeur.

Le dispositif de stockage et de transfert mécanique de condensateurs mères selon l'invention permet d'éviter ces inconvénients. Dans ce but, il est caractérisé en ce qu'il comporte des moyens pour supporter plusieurs barreaux parallélépipédiques disposés parallèlement entre eux et pour sélectionner un barreau à transférer après le transfert complet du précédent et des moyens d'avance dudit barreau pour assurer le transfert, les moyens pour supporter plusieurs barreaux parallélépipédiques et pour sélectionner un barreau comportant une pluralité de vis sans fin dont les rotations sont synchronisées, le pas de filet de chaque vis étant supérieur à la largeur du barreau qui vient se loger dans la gorge séparant les filets de celle-ci, la rotation de la vis assurant le déplacement latéral desdits barreaux lorsque le barreau à découper a été transféré, lesdites vis sans fin étant disposées selon un arc de cercle correspondant à la courbure des barreaux.

Selon un mode préférentiel de réalisation, la sinchronisation des vis sans fin peut être assurée par la liaison entre les differentes vis entre elles à l'aide de courroies crantées commandées par un moteur, cette pluralité de vis sans fin remplissant alors la double fonction de moyens pour supporter les barreaux et de moyens pour sélectionner un barreau à transférer, chacun de ces moyens pouvant toutefois comporter également d'autres dispositifs supplémentaires. Le dispositif selon l'invention comporte également une butée disposée à l'une des extrémités de l'ensemble des vis sans fin supportant les barreaux, butée permettant de positionner uniformément le début desdits barreaux. Il comporte également des moyens de détection de fin du barreau en cours de transfert, moyens qui engendrent un signal de commande au moteur de manière à positionner un nouveau barreau à transférer, par rotation simultanée des vis sans fin d'un pas.

Selon un autre mode de réalisation, chaque vis sans fin se termine par un rebord parallèle à la direction du transfert, le filetage de la vis se terminant avant ledit rebord de manière à obtenir une gorge parallèle à la direction de transfert.

L'invention sera mieux comprise à l'aide des exemples de réalisation suivants donnés à titre non limitatif, conjointement avec les figures qui représentent:

la fig. 1, une vue d'ensemble du dispositif selon l'invention,

la fig. 2, une vue de dessus de dispositif de la fig. 1,

la fig. 3, une vue de dessus du dispositif de la fig. 1,

la fig. 4, une vue de dessus de l'ensemble du dispositif de la fig. 1.

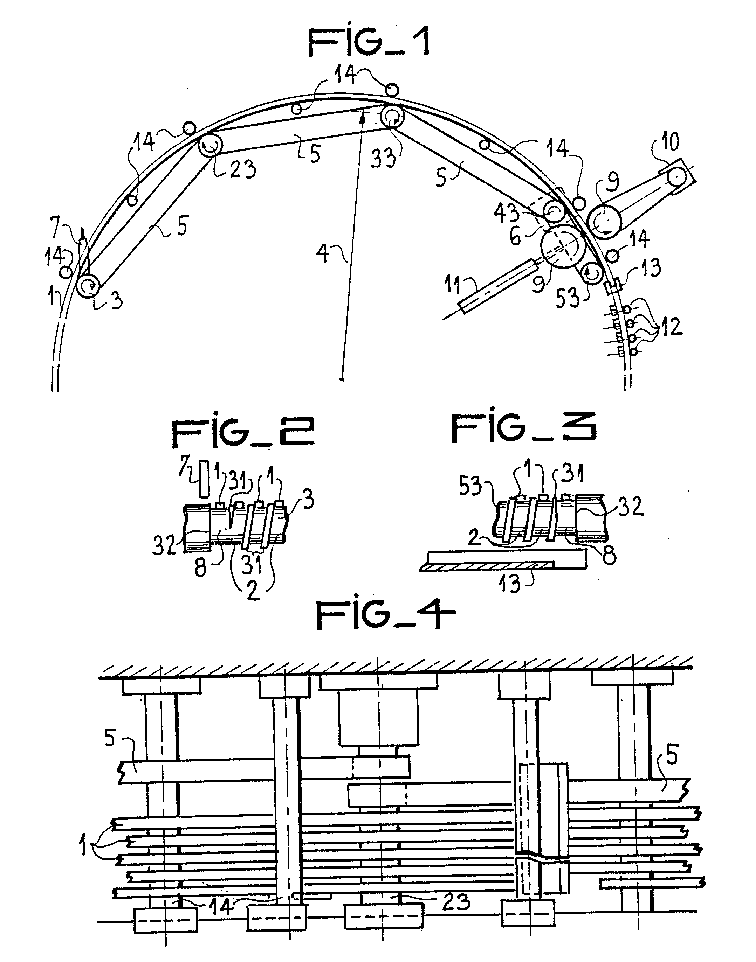

Sur la fig. 1, sont disposées sensiblement suivant un cercle de rayon 4 adapté, des vis sans fin selon l'invention, telles que 3, 23, 33, 43, 53. Ces vis sont reliées entre elles par des courroies crantées 5 entrainées en rotation par un moteur 6. Les barreaux 1 à stocker et à transférer sont disposés dans les filets desdites vis (voir figures suivantes). Des guides antiretour 14, de forme cylindrique sont régulièrement disposés le long de l'arc de cercle de rayon 4 de manière à guider les barreaux en cours de stockage et de transfert. Des galets d'entraînement 9, l'un supérieur et fixe, l'autre inférieur et mobile à l'aide d'un vérin 11 permettent de prendre et de transférer le barreau choisi. Une butée 13 (représentée plus en détail sur la fig. 3) permet de bloquer les barreaux en cours de stockage. Cette butée s'efface devant le barreau à transférer. A l'extrémité inférieure droite de la fig. 1, sont disposés des galets mobiles 12 constituant un chemin de roulement entrainant le barreau transféré vers, par exemple, des moyens de coupe non représentés sur la figure.

Sur la fig. 2, est représentée une vue partielle de dessus de l'appareil de la fig. 1. La vis sans fin 3 comporte un filetage continu 31, les filets étant séparés par des gorges 2 de largeur légèrement supérieure à la largeur des barreaux 1 de section parallélépipédique comme représenté sur la fig. 2. Le filet 31 se termine avant d'atteindre le rebord 32 de la vis de manière à créer une gorge circulaire 8 dans laquelle est logé le barreau 1 en cours de transfert. Les barreaux situés dans les gorges telles que 2 ont en effet leur extrémité bloquée par la butée 13 ainsi que cela est représenté sur la fig. 3. Sur cette figure, la vis 53 a la même structure que la vis 3. Le barreau transféré circule dans la gorge 8 en s'appuyant sur le rebord 32 et l'extrémité du filetage 31, ladite gorge étant circulaire. La butée 13 se termine sensiblement au niveau de la fin du filetage 31 de telle sorte que le barreau 1 en cours de transfert, situé le plus à droite sur cette fig. 3 ne soit pas gêné par cette butée 13.

Le fonctionnement de ce dispositif est le suivant: on charge manuellement une pluralité de barreaux 1 dans les gorges correspondantes 2 des vis sans fin 3, 23, 33, 43 et 53, un seul barreau étant disposé dans une gorge. Sous l'action d'un moyen de commande extérieur non représenté sur la figure, les galets d'entraînement 9 prennent le barreau 1 situé dans la gorge circulaire 8 et l'entraînent vers des moyens de découpe non représentés sur la figure. Le capteur 7 disposé au-dessus de la vis 3 à proximité de la gorge circulaire 8 détecte la fine du barreau se trouvant dans cette gorge circulaire. La distance séparant la vis 3 de la vis 53 étant connue d'une part ainsi que la vitesse de rotation des galets d'entraînement 9 d'autre part, le temps séparant le passage de la fin du barreau dans la gorge circulaire 8 au-dessus du capteur 7 et la fin du barreau à la sortie de la vis 53 est donc connue. Le capteur 7 engendre donc un signal, retardé de cette valeur connue ou prédéterminée au moteur 6 qui à réception de celui-ci, provoque une rotation de 360° de l'ensemble des vis 3, 23, 33, 43 et 53. Par conséquent, le barreau qui se trouvait dans la gorge 2 adjacente à la gorge circulaire 8 est maintenant transféré dans celle-ci et son transfert vers les moyens de découpe s'effectue comme celui du barreau précédent.

La fig. 4 représente une vue partielle de dessus du dispositif de la fig. 1. Sur cette figure, les mêmes éléments que ceux des figures précédentes portent les mêmes références. On notera en particulier les ensembles tels que 14 qui permettent le maintien et le guidage des barreaux parallélépipédiques 1. Sur cette figure, les filets de vis sans fin n'ont pas été représentés afin de simplifier celle-ci. D'une manière générale, on comprendra que la profondeur des gorges 2 entre les filets 31 sera fonction du pas de la vis et de la longueur des barreaux, de manière à assurer le passage sans contraintes latérales du barreau 1.

## Revendications

1. Appareil de stockage et de transfert mécanique de condensateurs mères en forme de barreaux sensiblement parallélépipédiques présentant une courbure, le transfert s'effectuant parallèlement à l'un des côtés des barreaux, caractérisé en ce qu'il comporte des moyens pour supporter plusieurs barreaux parallélépipédiques disposés parallèlement entre eux et pour sélectionner un barreau à transférer après le transfert complet du précédent et des moyens d'avance dudit barreau (1) pour assurer le transfert, les moyens pour supporter plusieurs barreaux parallélépipédiques et pour sélectionner un barreau (1) comportant une pluralité de vis sans fin (3, 23, 33, 43, 53), dont les rotations sont synchronisées, le pas du filet de chaque vis étant supérieur à la largeur des barreaux (1) qui viennent se loger dans la gorge séparant les filets de celle-ci (3), la rotation de la vis assurant le déplacement latéral desdites barreaux (1) lorsque le barreau précédent a été transféré, lesdites vis sans fin étant disposées selon un arc de cercle correspondant à la courbure des barreaux.

2. Appareil selon la revendication 1, caractérisé en ce qu'il comporte également une butée (13) disposée à l'une de ses extrémités permettant de positionner le début des barreaux (1).

3. Appareil selon la revendication 2, caractérisé en ce que la butée (13) sur laquelle s'appuie l'extrémité des barreaux (1) en cours de stockage s'efface devant le barreau à transférer.

4. Appareil selon la revendication 2, caractérisé en ce que la butée (13) se termine sensiblement au niveau se la fin du filetage (31) des vis.

5. Appareil selon l'une des revendications 1 à 4, caractérisé en ce qu'il comporte également des moyens de détection de la fin du barreau (1) à transférer, lesdits moyens commandant la rotation de chaque vis (3).

6. Appareil selon l'une des revendications 1 à 5, caractérisé en ce que les vis (3) sont reliées entre elles par une courroie commandée par un moteur.

7. Appareil selon l'une des revendications 1 à 6, caractérisé en ce que chaque vis (3) se termine par un rebord parallèle à la direction de transfert, le filet de chaque vis se terminant avant ledit rebord de manière à obtenir une gorge parallèle à la direction de transfert correspondant à la gorge dans laquelle se trouve le barreau (1) à transférer.

## Patentansprüche

1. Gerät zur Lagerung und zum mechanischen Transport von Mutterkondensatoren in Form von im wesentlichen parallelepipedischen, eine Krümmung aufweisenden Streifen, wobei der Transport parallel zu einer der Streifenseiten erfolgt, dadurch gekennzeichnet, dass es Mittel zum Tragen mehrerer parallelepipedischer parallel zueinander angeordneter Streifen und zur Auswahl eines zu transportierenden Streifens nach Abschluss des Transports des vorhergehenden sowie Mittel zum Vorschub dieses Streifens (1) aufweist, um den Transport zu bewirken, wobei die Mittel zum Tragen mehrerer parallelepipedischer Streifen und zur Auswahl eines Streifens (1) eine Vielzahl von Endlosschrauben (3, 23, 33, 43, 53) enthalten, deren Drehungen synchronisiert sind und deren Gewindegang grösser als die Breite der Streifen (1), die in der Nut zwischen den Gewindegraten (3) liegen, wobei die Schraubendrehung die seitliche Verschiebung der Streifen (1) bewirkt, wenn der vorhergehende Streifen transportiert worden ist, und wobei die Endlosschrauben entlang eines Kreisbogens entsprechend der Krümmung der Streifen angeordnet sind.

2. Gerät nach Anspruch 1, dadurch gekennzeichnet, dass es ausserdem einen Anschlag (13) aufweist, der an einem der Geräteenden liegt und den Anfang der Streifen (1) in Stellung bringt.

3. Gerät nach Anspruch 2, dadurch gekennzeichnet, dass der Anschlag, an dem das Ende der Streifen während der Lagerung anliegt, vor dem zu transportierenden Streifen verschwindet.

4. Gerät nach Anspruch 2, dadurch gekennzeichnet, dass der Anschlag (13) im wesentlichen in Höhe des Endes des Gewindes (31) der Schrauben endet.

5. Gerät nach einem der Ansprüche 1 bis 4, dadurch gekennzeichnet, dass es auch Mittel enthält, mit denen das Ende des zu transportierenden Streifens (1) erkannt wird und die die Drehung jeder Schraube (37 steuern.

6. Gerät nach einem der Ansprüche 1 bis 5, dadurch gekennzeichnet, dass die Schrauben (3) untereinander über einen von einem Motor gesteuerten Treibriemen verbunden sind.

7. Gerät nach einem der Ansprüche 1 bis 6, dadurch gekennzeichnet, dass jede Schraube (3) am Ende einen Rand besitzt, der parallel zur Transportrichtung liegt, wobei des Gewinde jeder Schraube vor diesem Rand zuendegeht, so dass sich eine zur Transportrichtung parallele Nut ergibt entsprechend der Nut, in der der zu transportierende Streifen (1) sich befindet.

## Claims

1. An apparatus for storing and mechanically transferring master capacitors in the form of substantially parallelepipedic bars having a curvature, the transfer being directed parallelly to one of the sides of the bars, characterized in that it comprises means for supporting several parallelepipedic bars in a mutually parallel disposition and for selecting one bar to be transferred after the complete transfer of the preceding one, and means for advancing said bar (1) in order to obtain its transfer, the means for supporting several parallelepipedic bars and for selecting one bar (1) comprising a plurality of synchroneously rotating endless screws (3, 23, 33, 43, 53), the thread pitch of each screw being larger than the width of the bars (1) which are put into the groove separating the threads thereof (3), the rotation of the screw ensuring the lateral displacement of said bars (1) when the preceding bar has been transferred, said endless screws being disposed along an arc of a circle corresponding to the curvature of the bars.

2. An apparatus according to claim 1, characterized in that it further comprises a stop (13) disposed at one of its ends and allowing the end of the bars (1) to be positioned.

3. An apparatus according to claim 2, characterized in that the stop (13) on which the end of the bars (1) is applied as long as they are stored, becomes obliterated in front of the bar to be transferred.

4. An apparatus according to claim 2, characterized in that the stop (13) ends substantially at the level of the end of the thread (31) of the screws.

5. An apparatus according to one of claims 1 to 4, characterized in that it further comprises means for detecting the end of the bar (1) to be transferred, said means controlling the rotation of each screw (3).

6. An apparatus according to one of claims 1 to 5, characterized in that the screws (3) are mutually coupled by a belt driven by a motor.

7. An apparatus according to one of claims 1 to 6, characterized in that each screw (3) terminates by an edge which is parallel to the direction of transfer, the thread of each screw ending before said edge so as to obtain a groove which is parallel to the transfer direction and which corresponds to the groove in which the bar (1) to be transferred is located.

# FIG_1

# FIG_2

# FIG_3

# FIG_4